# EUROPEAN PATENT APPLICATION

(11) **EP 4 543 156 A1**
(43) Date of publication of application: **23.04.2025**
(21) Application number: 24207002.7
(22) Date of filing: 16.10.2024
(51) Int. Cl.: H05K 7/20

(54) **AUDIO AMPLIFIER AND METHOD FOR COOLING AN AUDIO AMPLIFIER**

(30) Priority: 17.10.2023 IT 202300021636
(71) Applicant: POWERSOFT S.P.A., 50018 Scandicci (Firenze) (IT)
(72) Inventor: LASTRUCCI, Claudio, 50055 Lasta a Signa (Firenze) (IT)
(74) Representative: Conti, Marco

(57) **Abstract**

Described is an audio amplifier (1) for automotive applications comprising: a bottom wall (12), a shell (11), connected to the bottom wall (12) to form a housing space interposed between them and including a cooling plate (111), parallel to the bottom wall (12) and having an inside face (111A), facing the housing space, and an outside face (111B), the cooling plate (111) being provided with a finned portion (111C) projecting the outside face (111B) and a plurality of studs (111F) projecting from the inside face (111A) in the housing space, towards the bottom wall (12); an electronic card (15), positioned in the housing space and including a plurality of electronic components, positioned on the card (15) in such a way that the studs (111F) of the plurality of studs of the cooling plate (111) are abutted against them in contact; a lid (13), fixed to the shell (11) and positioned parallel to the bottom wall (12), in such a way that the finned portion (111C) is interposed between the lid (13) and the outside face (111B) of the cooling plate (111) for defining a duct system; a fan (14), positioned between the lid (13) and the outside face (111A) of the cooling plate (111), for generating a flow of air through the duct system.

## Description

The present invention relates to an audio amplifier and a method for cooling an audio amplifier.

In particular, the technical sector is that of the systems for the dissipation of heat developed inside audio amplifiers, in particular for the automotive application. The need is particularly felt in the automotive sector of dissipating heat in an effective manner in audio amplifiers with reduced dimensions.

Patent document US10076062B2 shows a heat dissipation system in an audio amplifier. The audio amplifier described comprises an electronic card positioned inside a container, which has fins on its outside surface. In particular, the electronic card is fastened inside the sides of the container at the relative edges. The heat generated by the components of the electronic card is transferred to the container at the points of contact and passes through the duct system defined by the fins. However, the arrangement of the electronic board inside the internal space of the container makes the transfer of heat from the electronic board to the fins not very efficient. Moreover, due to the arrangement of the fins and its general shape, the audio amplifier US10076062B2 is not very suitable for being mounted inside a vehicle.

Patent documents WO2018/196141A1, EP3349555A1 and JP2022110640A describe examples of dissipation system in an audio amplifier; however, even those systems do meet the market needs.

The aim of this invention is to provide an audio amplifier and a method for cooling an audio amplifier which overcome the above-mentioned drawbacks of the prior art.

In particular, the aim of this invention is to provide an audio amplifier and a method for cooling an amplifier which allows the heat to be dissipated in an efficient manner.

The aim of this invention is also to provide an audio amplifier and a method for cooling an amplifier wherein the electronic card is protected from agents outside the amplifier.

A further aim of this invention is to provide a compact amplifier circuit suitable for being installed in a vehicle.

Said aims are fully achieved according to the invention as characterised in the appended claims.

In particular, the audio amplifier comprises a bottom wall. The audio amplifier comprises a shell. The shell is connected to the bottom wall to form an interposed housing space. Preferably, the housing space is a (substantially) closed space.

The audio amplifier comprises a cooling plate. In particular, the shell includes a cooling plate. The cooling plate is parallel to the bottom wall. Preferably, the cooling plate defines a front wall of the shell. The cooling plate has an inside face, facing the housing space, and an outside face, opposite the inside face.

The cooling plate is provided with a finned portion. The finned portion projects from the outside face. In particular, the finned portion includes a plurality of fins. Each fin has an extension (a length) on a plane (that is, along a plane) defined by the cooling plate. Each fin extends between a first and a second end. Each fin has a height or depth on a plane (that is, along a plane) transversal (or parallel) to a plane defined by the cooling plate. Each fin projects from the outside face of the cooling plate. More specifically, each fin projects from the outside face in the opposite direction relative to the housing space.

The amplifier, in particular the cooling plate, comprises a plurality of studs. The studs project from the inside face in the housing space, towards the bottom wall.

The amplifier comprises an electronic card. The electronic card is positioned in the housing space. The electronic card is configured for processing (that is, amplifying) an audio signal. The electronic card comprises a plurality of electronic components. The studs of the plurality of studs are abutted on the electronic card, that is to say, in contact with the electronic card. In particular, the electronic components are positioned on the card in such a way that the studs of the plurality of studs of the cooling plate are abutted against them in contact. According to an example, the electronic components are all located on the electronic board. Preferably, the electronic card is positioned inside the housing space parallel to the bottom wall. According to an example, a distance between the bottom wall and the electronic card is less than a distance between the electronic card and the cooling wall.

In an example, the amplifier comprises a lid. The lid is fixed to the shell, in particular on the front wall of the shell. The lid is positioned parallel to the bottom wall, so that the finned portion is interposed between the lid and the outside face of the cooling plate for defining a duct system. The purpose of the studs of the plurality of studs is to transfer heat generated by the electronic card (that is, by the electronic components) to the cooling plate, in an efficient manner.

The amplifier comprises a fan, configured to generate a flow of air. The fan is configured for generating a flow of air through the dust system. In particular, the fan is configured for generating a flow of delivery air through the duct system and towards the fan. In particular, the fan is configured for generating a flow of return air from the fan. The purpose of the flow of air generated by the fan is to transport the heat generated by the electronic card and transported to the cooling plate by the plurality of studs, through the duct system. In particular, it may be noted that the flow of air is outside the housing space and therefore does not directly touch the electronic card or the electronic components located in the housing space. In other words, the path of the air flow is separate from the electronic components. This aspect brings the advantage of preserving the electronic card and its components from any contamination by external agents, such as, for example, dirt and moisture.

In an embodiment, the lid is attached to the shell so as to define a cooling volume. The cooling volume results at least partly open to the environment outside the amplifier. Preferably, the cooling volume and the housing space are isolated from each other. The housing volume results isolated from the environment outside the amplifier.

The lid can be attached to the shell so that the fan is at least partially covered; in other words, the fan results interposed between the lid and the shell.

According to an example embodiment, the studs of the plurality of studs are located (exclusively) at the finned portion of the cooling plate. In this way, since the studs abut the electronic card at the electronic components, the transfer of heat is optimised, limiting it to those zones in which it is produced most.

The cooling plate may comprise one or more portions not finned (thus without fins), that is, one or more flat portions. Preferably, at the non-finned portions, there are no studs.

For example, the shell includes a lateral wall. The lateral wall protrudes from the cooling plate (that is, from the front wall). The lateral wall is perpendicolar to an extension plane of the cooling plate (that is, the front wall). The lateral wall is connected to the cooling plate (that is, to the front wall) along a perimeter of the cooling plate. The lateral wall may comprise a front face. The amplifier comprises one or more electrical connectors, connected to the electronic card. The one or more electrical connectors can be positioned on the front face of the lateral wall.

The amplifier comprises an outlet opening for air. The outlet opening is in fluid communication with the finned portion, in particular, it is in communication with the fins of the plurality of fins.

According to an embodiment, the front face of the lateral wall defines an outlet opening in fluid communication with the duct system. In other words, the front face of the lateral wall comprises an outlet opening (the outlet opening). The fan may be positioned between the finned portion and the outlet opening.

Preferably, the lid comprises a grid. The grid may be positioned at the outlet opening. In particular, the lid may be coupled to the shell in such a way that the grid is positioned at the outlet opening of the lateral wall.

For this reason, the air flow generated by the fan escapes from the outlet opening.

Preferably, the grid is made in one piece with the lid.

In an embodiment, the duct system is positioned radially.

The duct system has a plurality of inlet holes. For this reason, the flow of air generated by the fan enters into the duct system from the plurality of inlet holes through the duct system and exits from the outlet opening.

The lateral wall may have a first lateral face and a second lateral face. The second lateral face is opposite the first lateral face. The first and second lateral faces are separated from the front face. The lateral wall may have a rear face, opposite the front face. The first and second lateral faces are separated from the rear face. The first and second lateral faces, the front face and the rear face define a lateral wall having a rectangular shape. Preferably, the plurality of inlet holes are positioned on the rear face and/or on the first lateral face and/or on the second lateral face.

More preferably, the plurality of inlet holes is positioned on the rear face, on the first lateral face and on the second lateral face. The inlet holes, being positioned on three separate sides of the lateral wall, facilitate the entrance of fresh air even in situations of positioning the amplifier which are not optimum, for example in the case of partial occlusion of one of the faces of the lateral wall caused by the positioning of the amplifier inside the vehicle.

In an embodiment, the fins of the plurality of fins are arranged radially. Each fin extends between a first end and a second end. The first end is prozimal to the fan. The second end is proximal to the lateral wall of the shell. In an embodiment, the second end is proximal to at least one between the rear face, the first side face and the second side face. In other words, the second ends of the fins can be distributed by at least one between the rear face, the first side face and the second side face. According to an example, the outlet opening is positioned on the front face in a central position. The duct system includes a plurality of ducts.

The duct system comprises a plurality of inlet holes. In an example, each duct is defined by a pair of adjacent fins. Each duct defines an inlet hole. Specifically, the inlet hole is defined by the second ends of the pair of adjacent fins. The inlet holes can be arranged on the side wall of the shell. In an embodiment, the inlet holes are arranged on at least one between th rear face, the first side face and the second side face.

The duct system has a plurality of outlet holes. In one example, each duct defines an outlet hole. Specifically, the outlet hole is defined by the first ends of a pair of adjacent fins.

The inlet holes are arranged on the side wall of the shell and the outlet holes are in fluid communication with the outlet opening, via the fan. So the air enters through the inlet holes, passes through the ducting to the outlet holes and exist, forced by the fan, through the outlet opening.

In an embodiment, the duct system di arranted radially. In particular, the ducts are arranged radially.

Preferably, the ducts are positioned radially, for putting in communication the outlet opening with the inlet holes of the duct system.

According to an example, the shell is made of heat conductive metallic material. According to an example, the shell is made in one piece. In other words, the shell is made of heat conductive solid material. According to an example, the shell is made by die-casting.

According to an embodiment, the electronic components abutted against the studs of the plurality of studs include power devices. The electronic components (that is, the power devices) may include power switches and/or integrated electronic power components.

According to an example embodiment, the amplifier, in particular the shell and/or the bottom wall, comprises a group of fastening studs (projecting from the inside face), connected to the electronic card and to the shell and/or to the bottom wall of the amplifier. In particular, the studs of the group of fastening studs are configured for fastening the electronic card to the shell and/or to the bottom wall by means of fastening screws. Preferably, the fastening studs of the group of fastening studs project from the inside face in the housing space, towards the bottom wall, and are configured for fastening the electronic card to the shell by means of fastening screws.

The fan is configured to rotate around an axis of rotation. Preferably, the axis of rotation is perpendicular to a plane defined by the cooling plate. Specifically, the axis of rotation is perpendicular to an extension direction of the fines (in other words, the axis of rotation is perpendicular to the duct system).

According to an example, the fan includes a plurality of blades, positioned circularly about an axis of rotation and configured to rotate about the axis of rotation. Preferably, the axis of rotation is perpendicular to a plane defined by the cooling plate. The fan may include a housing and the plurality of blades may be positioned inside the housing. The housing is preferably box-shaped. The housing may be elongate mainly along a plane of extension parallel to a plane defined by the cooling plate. In other words, the housing may be elongate mainly along a plane of extension perpendicular to the axis of rotation of the plurality of blades. By rotating the blades, the fan generates a flow of air. In particular, the fan is configured to generate a delivery flow towards the fan and a return flow from the fan, by rotation of the blades.

The housing has an inlet for the air and an outlet for the air. The delivery flow enters the housing through the inlet and exits through the outlet. Preferably, the inlet is positioned on the plane of extension of the housing. The inlet may have a circular shape. The inlet may be positioned at the plurality of blades aligned with the axis of rotation. Preferably, the outlet is positioned on a plane perpendicular to the plane of extension of the housing (that is, parallel to the axis of rotation). When the fan is positioned in the audio amplifier, the outlet of the housing is positioned at the outlet opening. The fan is configured for sucking air from the inlet. The fan is configured for diffusing air radially to the axis of rotation and for conveying it at the outlet in a predetermined direction, through the outlet of the housing. This aspect has the aim of increasing the efficiency of the forced circulation by the fan, having a reduced space available in which to place the fan.

According to an example, the shell comprises, between the finned portion and the outlet opening, a seat. The seat constitutes, relative to a plane defined by the cooling plate (that is, relative to the finned portion) a recessed portion (that is, a depression) towards the bottom wall. The seat is configured to house the fan, that is to say, the fan is housed, at least partly, in the seat of the shell.

In particular, the seat has a first space and a second space. The first space and the second space are aligned along an axis perpendicular to a plane defined by the cooling plate. In particular, the first space is configured to house the fan, that is, the housing of the fan is located in the first space. The second space is isolated from the outside environment. The second space constitutes a compensation space for the air which arrives from the duct system and enters into the housing of the fan.

The seat of the shell comprises, at the first space, one or more supporting elements, configured to support the housing of the fan inside the first space. For example, the shell comprises a pair of pins, located in the seat close to the finned portion. The pair of pins may be configured for coupling to a corresponding pair of pins of the housing of the fan. The shell may comprise a supporting element, located in the seat close to the front face to support the housing of the fan. The fan is housed in the seat (in particular, in the first space) so that the outlet of the housing is aligned with the outlet opening.

The invention also provides a method for cooling an audio amplifier; preferably, the amplifier is made according to one or more aspects of the invention.

The method comprises a step of preparing a bottom wall. The method comprises a step of preparing a shell. The shell is connected to the bottom wall to form an interposed housing space. Preferably, the housing space is a (substantially) closed space.

The shell includes a cooling plate. The cooling plate is positioned parallel to the bottom wall, that is to say, the method comprises a step of preparing the cooling plate parallel to the bottom wall. The cooling plate has an inside face, facing the housing space, and an outside face, opposite the inside face.

The method may include a step of preparing the cooling plate with an inside face facing the housing space.

The cooling plate is provided with a finned portion. In other words, the method may include a step of preparing a finned portion in the cooling plate. The finned portion projects from the outside face. In particular, the finned portion includes a plurality of fins. Each fin has an extension (a length) on a plane (that is, along a plane) defined by the cooling plate. Each fin has a height or depth on a plane (that is, along a plane) transversal (or parallel) to a plane defined by the cooling plate. Each fin projects from the outside face of the cooling plate. More specifically, each fin projects from the outside face in the opposite direction relative to the housing space.

The cooling plate includes a plurality of studs. The studs project from the inside face in the housing space, towards the bottom wall. In other words, the method may include a step of preparing a plurality of studs projecting from the inside face in the housing space, towards the bottom wall.

The method comprises a step of preparing an electronic card.

The electronic card is positioned in the housing space, that is, the step of preparing the electronic card comprises positioning the electronic card in the housing space. The electronic card processes (that is, amplifies) an audio signal.

The electronic board includes a plurality of electronic components. The studs of the plurality of studs are abutted on the electronic card, that is to say, in contact with the electronic card. In particular, the electronic components are positioned on the card in such a way that the studs of the plurality of studs of the cooling plate are abutted against them in contact. According to an example, the method comprises a step of preparing a lid. The lid is fixed to the shell. The lid is positioned parallel to the bottom wall, so that the finned portion is interposed between the lid and the outside face of the cooling plate for defining a duct system.

The method comprises a step of generating, by a fan, a flow of air. The method may comprise a step of preparing a fan. Preferably, the fan is positioned between the lid and the outside face of the cooling plate. The air flow passes through the duct system.

There may be a step of passing an air flow, generated by the fan, through the duct system.

The method may include a step of transferring heat, generated by the electronic components of the electronic card, from the electronic components to the cooling plate. The method may include a step of transporting the heat, by the flow of air generated by the fan, through the duct system of the cooling plate.

According to an example embodiment, the studs of the plurality of studs are located (exclusively) at the finned portion of the cooling plate. The method may include a step of transferring heat, by the studs of the plurality of studs, from the electronic components of the electronic card to the finned portion of the cooling plate.

The cooling plate may comprise one or more portions not finned (thus without fins), that is, one or more flat portions. Preferably, at the non-finned portions, there are no studs.

For example, the shell includes a lateral wall. The lateral wall is connected to the cooling plate (that is, to the front wall) along a perimeter of the cooling plate. The lateral wall may comprise a front face. The amplifier comprises one or more electrical connectors, connected to the electronic card. The one or more electrical connectors can be positioned on the front face of the lateral wall.

According to an embodiment, the front face of the lateral wall defines an outlet opening in fluid communication with the duct system. The fan may be positioned between the fins and the outlet opening. The method may comprise a step of preparing a lateral wall in the shell, comprising a front face and a step of preparing one or more electrical connectors, connected to the electronic card and positioned on the front face of the lateral wall. The method may comprise a step of positioning the fan between the fins and the outlet opening, prepared in the front face of the lateral wall. The method may comprise a step of fluid communication between the outlet opening and the fins through the fan.

In particular, the shell includes a lateral wall having a front face defining an outlet opening and the method comprises a step of passage of air between the fins and the outlet opening, through the fan, positioned between the fins and the outlet opening.

According to an example, the outlet opening is positioned on the front face in a central position. The duct system includes a plurality of ducts. Preferably, the ducts are positioned radially, for putting in communication the outlet opening with the inlet holes of the duct system.

According to an example, the shell is made of heat conductive metallic material. According to an example, the shell is made in one piece. In other words, the shell is made of heat conductive solid material. According to an example, the shell is made by die-casting.

The lateral wall may have a first lateral face and a second lateral face. The second lateral face is opposite the first lateral face. The first and second lateral faces are separated from the front face. The lateral wall may have a rear face, opposite the front face. The first and second lateral faces are separated from the rear face. The first and second lateral faces, the front face and the rear face define a lateral wall having a rectangular shape. Preferably, the plurality of inlet holes is positioned on the rear face and/or on the first lateral face and/or on the second lateral face.

More preferably, the plurality of inlet holes is positioned on the rear face, on the first lateral face and on the second lateral face.

The method may include a step of entering a flow of air through the plurality of inlet holes. The method may include a step of passage of the air flow, through the duct system. The method may include a step of escape of the flow of air through the outlet opening.

According to an example, the electronic components abutted against the studs of the plurality of studs comprise power devices. The electronic components (that is, the power devices) may include power switches and/or integrated electronic power components.

According to an example embodiment, the method comprises a step of preparing a group of fastening studs in the shell and/or in the bottom wall and connected to the electronic card and to the shell and/or to the bottom wall. The method may comprise a step of fastening the electronic card to the shell and/or to the bottom wall using fastening screws.

Preferably, the method comprises a step of preparing a group of fastening studs projecting from the inside face in the housing space towards the bottom wall and a step of fastening the electronic card to the shell by means of fastening screws, through the fastening studs.

According to an example, the fan includes a plurality of blades, positioned circularly about an axis of rotation. The method may comprise a step of rotating the plurality of blades about the axis of rotation. Preferably, the axis of rotation is perpendicular to a plane defined by the cooling plate. The fan may include a housing and the plurality of blades may be positioned inside the housing. The housing is preferably box-shaped. The housing may be elongate mainly along a plane of extension parallel to a plane defined by the cooling plate. In other words, the housing may be elongate mainly along a plane of extension perpendicular to the axis of rotation of the plurality of blades. By rotating the blades, the fan generates a flow of air. In particular, the fan generates a delivery flow towards the fan and a return flow from the fan, by rotation of the blades.

The housing has an inlet for the air and an outlet for the air. The delivery flow enters the housing through the inlet and exits through the outlet. Preferably, the inlet is positioned on the plane of extension of the housing. The inlet may have a circular shape. The inlet may be positioned at the plurality of blades aligned with the axis of rotation. Preferably, the outlet is positioned on a plane perpendicular to the plane of extension of the housing (that is, parallel to the axis of rotation). When the fan is positioned in the audio amplifier, the outlet of the housing is positioned at the outlet opening. The method may comprise a step of sucking air, by the fan, from the inlet of the housing. The method may comprise a step of diffusing air radially to the axis of rotation. The method may comprise a step of conveying or passage of the air in a predetermined direction, through the outlet of the housing.

According to an example, the shell comprises, between the finned portion and the outlet opening, a seat. The seat constitutes, relative to a plane defined by the cooling plate (that is, relative to the finned portion) a recessed portion (that is, a depression) towards the bottom wall.

The fan may be housed, at least partly, in the seat of the shell.

In particular, the seat has a first space and a second space. The first space and the second space are aligned along an axis perpendicular to a plane defined by the cooling plate. In particular, the housing of the fan is located in the first space. The second space is isolated from the outside environment. The second space constitutes a compensation space for the air which arrives from the duct system and enters into the housing of the fan.

The seat of the shell comprises, at the first space, one or more supporting elements, to support the housing of the fan inside the first space. For example, the shell comprises a pair of pins, located in the seat close to the finned portion. The pair of pins may couple to a corresponding pair of pins of the housing of the fan. The shell may comprise a supporting element, located in the seat close to the front face to support the housing of the fan. The fan is housed in the seat (in particular, in the first space) so that the outlet of the housing is aligned with the outlet opening.

This and other features will become more apparent from the following description of a preferred embodiment of the invention, illustrated by way of non-limiting example in the accompanying drawings, in which:

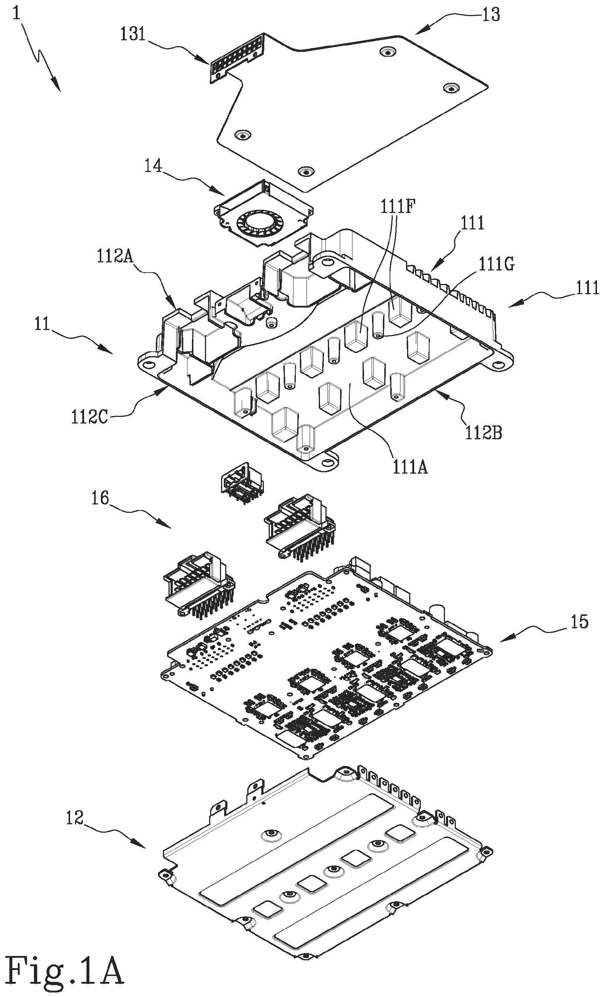

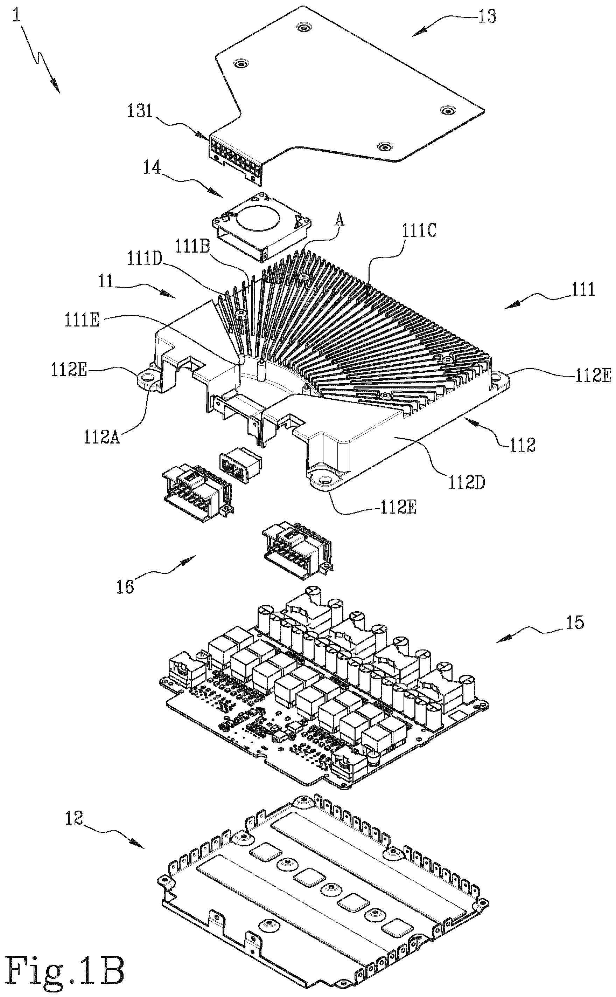

- Figures 1A and 1B illustrate an exploded view of an audio amplifier according to one or more aspects of the invention;

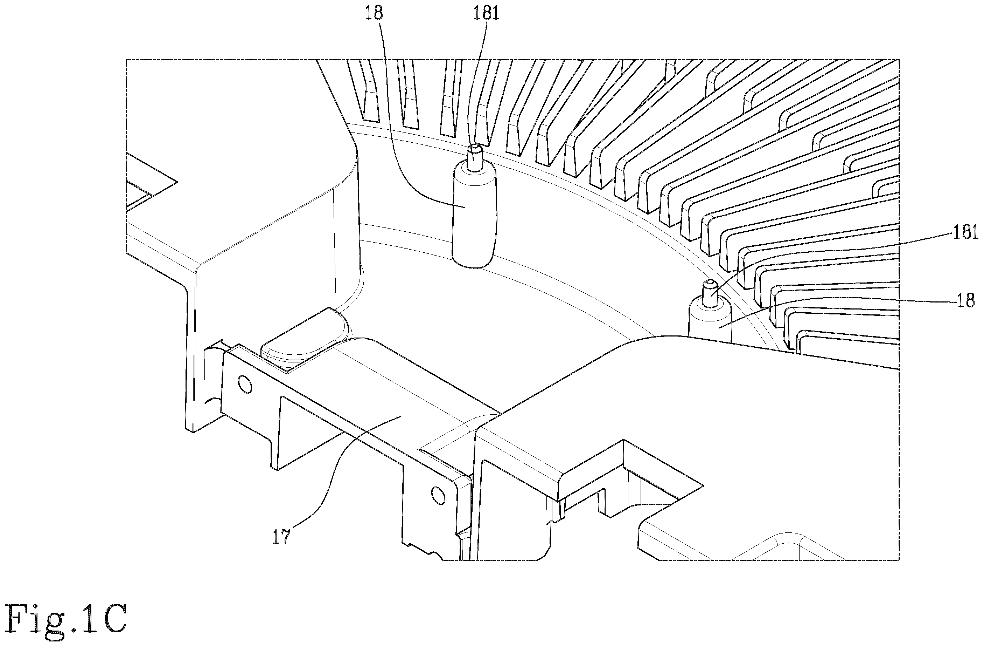

- Figure 1C illustrates an enlargement of a detail of Figure 1B;

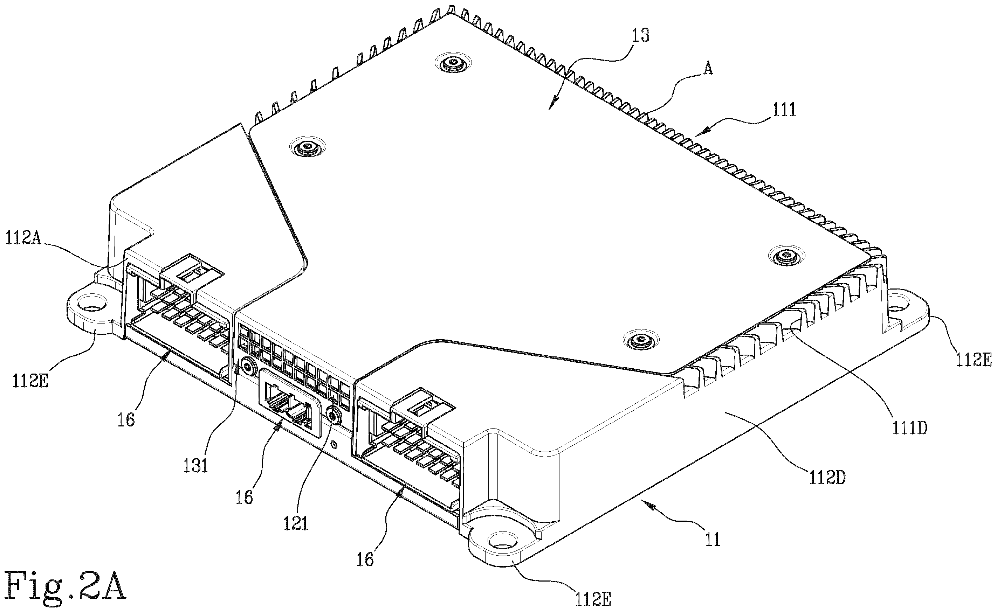

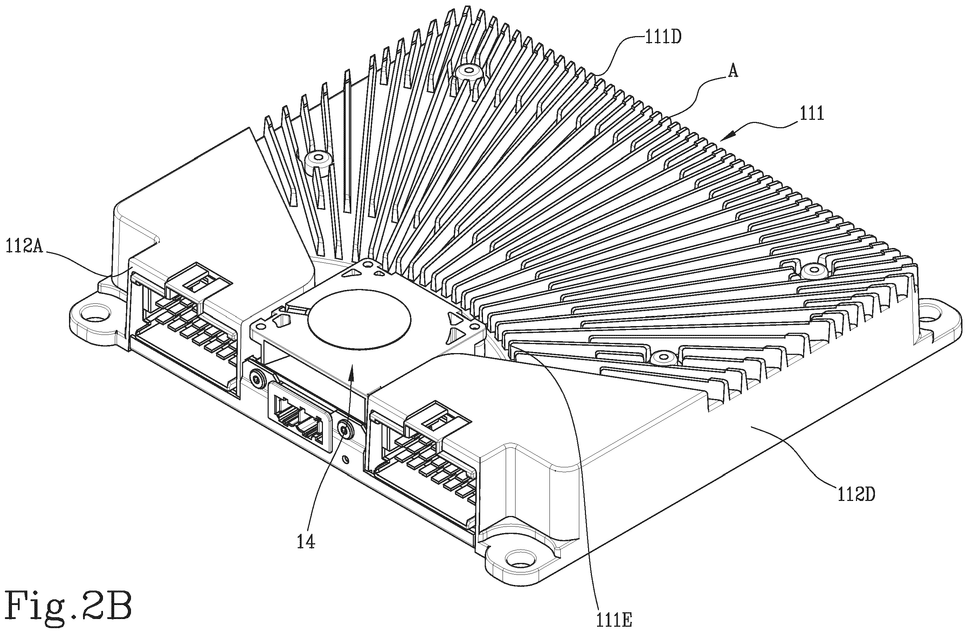

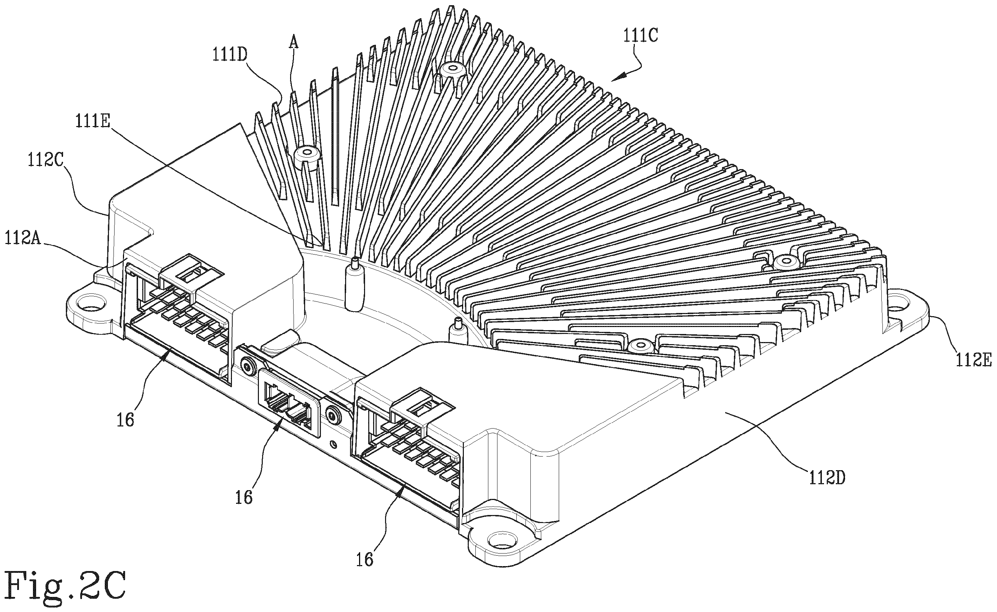

- Figures 2A-2C illustrate an audio amplifier according to one or more aspects of the invention;

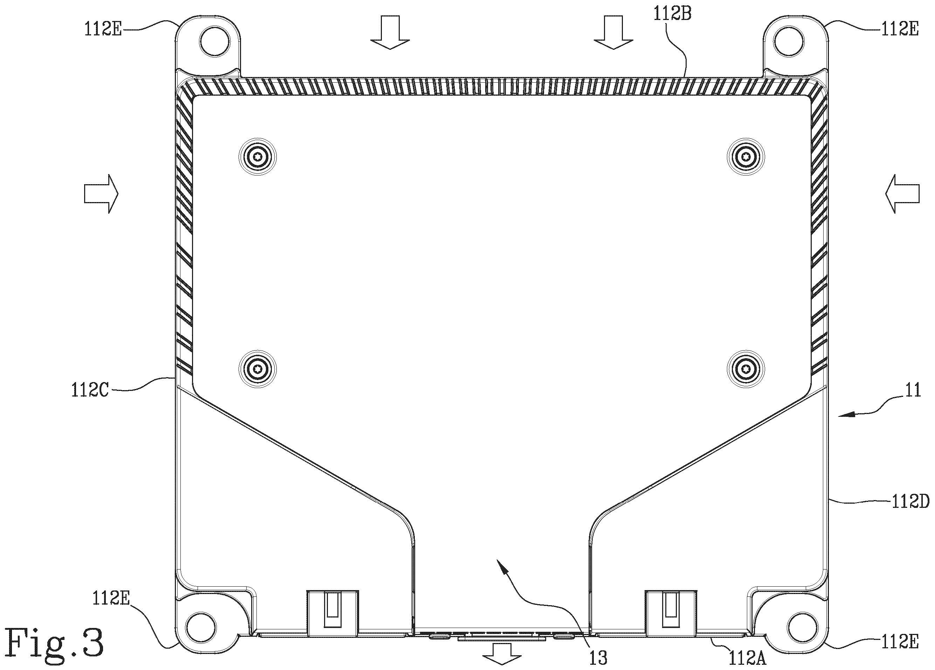

- Figure 3 illustrates an audio amplifier according to one or more aspects of the invention, wherein the direction of the air flow is schematically shown;

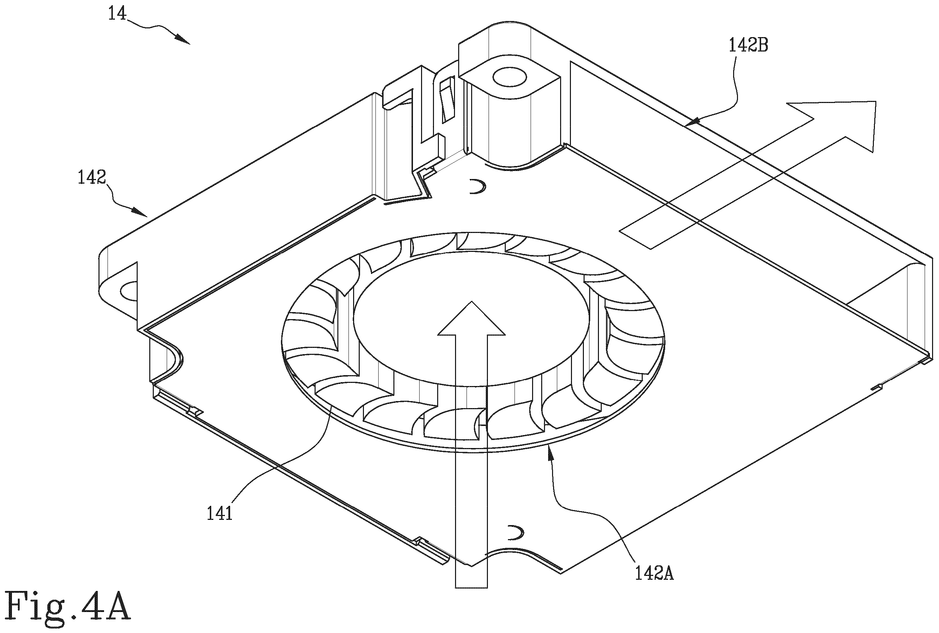

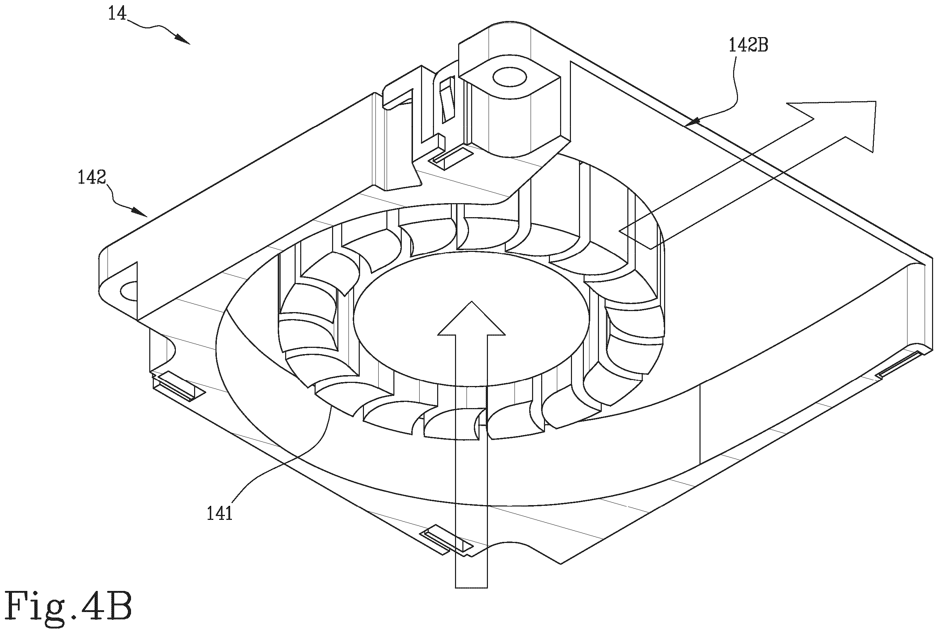

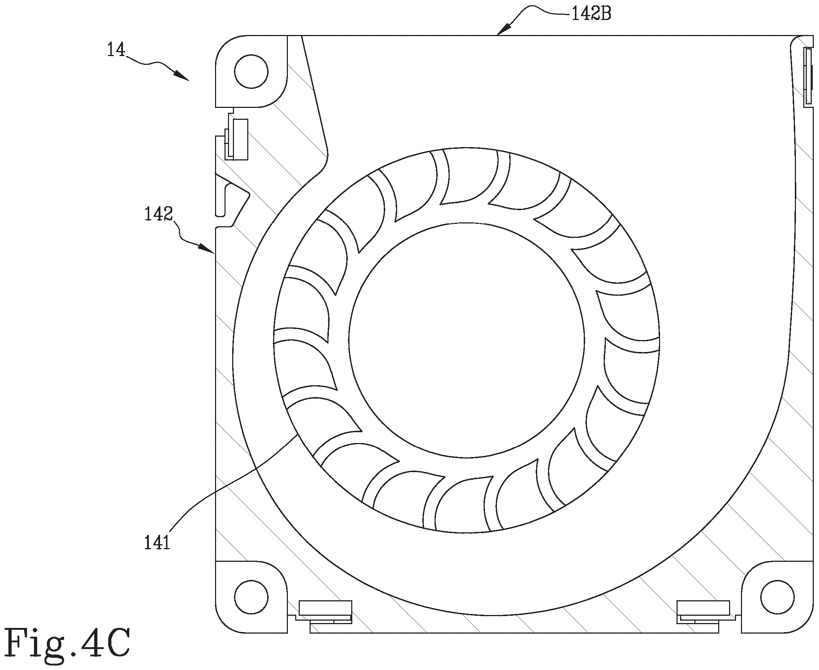

- Figures 4A-4C illustrate a fan of an audio amplifier according to one or more aspects of the invention.

In the accompanying drawings, the numeral 1 denotes an audio amplifier. The audio amplifier 1 comprises a shell 11 and a bottom wall 12. The shell 11 and the bottom wall 12 are connected to each other to form a housing space substantially closed relative to the outside environment.

The shell 11 includes a cooling plate 111, forming a front wall of the shell 11. The cooling plate 111 (that is, the front wall) is positioned parallel to the bottom wall 12. The cooling plate 111 and the bottom wall 12 have substantially the same extension. The shell 11 includes a lateral wall 112. The lateral wall 112 is connected to the front wall (that is, to the cooling plate 111) along a perimeter of the front wall and is positioned perpendicularly to the front wall (that is, to the cooling plate 111) and to the bottom wall 12.

The lateral wall 112 has a front face 112A and a rear face 112B, opposite the front face 112A. The lateral wall 112 has a first lateral face 112C and a second lateral face 112D, opposite the first lateral face 112C. The first lateral face 112C and the second lateral face 112D are separated from the front face 112A and from the rear face 112B. The shell 11 and the bottom wall 12 define, together, a body having a box shape.

In particular, the lateral wall 112 comprises four corner elements 112E, positioned at the corners defined by the faces 112A, 112B, 112C and 112D of the lateral wall 112. The corner elements 112E project from the corners of the lateral wall 112 along a plane perpendicular to the lateral wall 112 (that is, parallel to the bottom wall 12 or to the cooling plate 111). Each corner element 112E comprises a slot. Each slot is configured to house a fastening screw so as to fasten the audio amplifier 1, for example on a supporting surface of a vehicle.

The cooling plate 111 has an inside face 111A, facing the housing space, and an outside face 111B, opposite the inside face 111A. The cooling plate 111 is provided with a finned portion 111C, projecting from the outside face 111B and including a plurality of fins A. Each fin A extends along a plane defined by the cooling plate 111 and extends in height in a plane transversal (or parallel) to the plane defined by the cooling plate 111. In particular, each fin A is spaced from the adjacent fins A.

The audio amplifier 1 comprises a lid 13. The lid 13 is preferably fixed to the front wall (that is, to the cooling plate 111) of the shell 11 and positioned parallel to the bottom wall 12 (that is, to the front wall). In this way, the finned portion 111C is interposed between the lid 13 and the outside face 112B of the cooling plate 111 for defining a duct system. In particular, the duct system is formed by the pairs of adjacent fins A.

The audio amplifier 1 comprises a fan 14, configured for generating a flow of air through the duct system.

In particular, the front face 112A of the lateral wall 112 has an outlet opening 121 so that the duct system and the outlet opening 121 are in fluid communication and the duct system is in communication with the outside environment. The fan 14 is positioned between the fins (the duct system) and the outlet opening 121.

In particular, the lid 13 comprises a grid 131. The lid 13 comprises a main wall which, when mounted to the shell 11, is parallel to the cooling plate 11. The grid 131 projects in a perpendicular direction from the main wall of the lid 13 so that, when the lid 13 is coupled to the shell 11, the grid 131 is positioned at the outlet opening 121.

The duct system has a plurality of inlet holes 111D, that is to say, each duct comprises an inlet hole 111D. The flow of air generated by the fan 14 enters from the plurality of inlet holes 111D and passes through the duct system (in particular, through the ducts). The inlet holes of the plurality of inlet holes 111D are positioned on the rear face 112B, on the first and second lateral faces 112C, 112D. The duct system has a plurality of outlet holes 111E. The outlet holes 111E are located at the fan 14. In particular, the ducts of the duct system are positioned radially between the outlet holes 111E and the inlet holes 111D. The outlet opening 121 is in fluid communication with the outlet holes 111E through the fan 14 and with the inlet holes 111D through the duct system. The flow of air enters the duct system from the inlet holes 111D, passes through the duct system and exits from the duct system through outlet holes 111E; subsequently, the flow of air enters in the fan 14 and exits from the fan and then escapes from the audio amplifier 1 through the outlet opening 121. In particular, the fan 14 may include a plurality of blades 141 and a housing 142. The blades 141 of the plurality are positioned inside the housing 142 and positioned circularly about an axis of rotation and are configured to rotate about the axis of rotation, so as to generate a flow of air. The axis of rotation of the blades 141 is positioned perpendicularly to the cooling plate 111. Preferably, the housing 142 is box-shaped and elongate mainly along a plane of extension parallel to a plane defined by the cooling plate 111 (in other words, the housing 142 is elongate along a plane of extension perpendicular to the axis of rotation of the blades 141). The housing 142 has an air inlet 142A and an air outlet 142B. The fan 14 is configured to generate a delivery flow towards the fan 14 and a return flow 14 from the fan 14. The delivery flow enters the housing 142 through the inlet 142A and exits through the outlet 142B of the housing. Preferably, the inlet 142A is positioned on the plane of extension of the housing 142. In particular, the inlet 142A is a circular opening located at the plurality of blades 142 about the axis of rotation. Preferably, the outlet 142A of the housing 142 is positioned on a plane perpendicular to the plane of extension of the housing 142, at the outlet opening 121. The fan 14 is a "fan unit".

The fan 14 is positioned on the shell 11 in such a way that the housing 142 is spaced from the upper surface of the cooling plate 111; in that way, an air volume is defined between the upper surface of the cooling plate 111 and the housing 142 of the fan which acts as a manifold; the manifold is in fluid communication with the duct system defined by the fins and is in fluid communication with the suction of the fan 14. The shell defines a central supporting surface 17, located in a position distal from the duct system, and a pair of spacer studs 18, located in a position proximal to the duct system; the housing 142 of the fan rests on the central supporting surface and on the spacer studs. Preferably, the spacer studs 18 are provided with contact pins 181 projecting towards the lid 13; the contact pins 181 are operatively inserted in corresponding holes made in the housing 142 of the fan, so as to ensure the correct positioning of the fan 14. When the lid 13 is fixed to the shell 11, the fan 14 is interposed between the lid, positioned above, and the central supporting surface 17 and the spacer studs 18, positioned below. The manifold air space is defined below the housing 142 (that is to say, below the fan 14). The purpose of the manifold air space is to collect the air from the ducts of the duct system and generate a zone with uniform pressure, from which the fan sucks the air (axially) and then presses it radially (relative to the impeller of the fan), through the outlet opening (protected by the grid 131). The length of the spacer studs 18 defines the height of the manifold air space measured parallel to the axis of rotation of the fan 14.

The audio amplifier 1 comprises an electronic card 15 configured for processing (that is, amplifying) an audio signal. The electronic card 15 is positioned in the housing space, parallel to the bottom wall 12. The electronic card 15 comprises a plurality of electronic components.

The cooling plate 111 includes a plurality of studs 111F projecting from the inside face 111A in the housing space, towards the bottom wall 12. The studs 111F of the plurality are abutted in contact with corresponding electronic components of the plurality of electronic components of the electronic card 15. In particular, the studs 111F extend between a first end, positioned on the inside face 111A of the cooling plate 111, and a second end, positioned in contact with the electronic components of the electronic card 15, so as to transfer the heat generated by the electronic components to the cooling plate 111. The studs 111F are located at the fins A (that is, at the finned portion) of the cooling plate 111.

The shell 11 (the cooling plate 111) includes a group of fastening studs 111G projecting from the inside face 111A in the housing space. The fastening studs 111G are configured for connecting the shell 11 to the bottom wall 12. In particular, the fastening studs 111G are configured for fastening the electronic card 15 inside the housing space, between the shell 11 (the cooling plate 11) and the bottom wall 12, for example by means of fastening screws.

The audio amplifier 1 comprises one or more electrical connectors 16, positioned on the front face 112A of the lateral wall 112, at the sides of the outlet opening 121. The electrical connectors 16 are connected to the electronic card 15.

During operation of the audio amplifier 1, the heat generated by the electronic card 15, in particular by the electronic components (more specifically by power devices of the electronic card 15), is transferred from the studs 111F towards the finned portion of the cooling plate 15. The fan 14 generates a flow of air through the duct system. The outside air enters through the inlet holes 111D of the duct system and is transported by the flow of air generated by the fan 14 through the duct system. During the passage through the duct system, the air heats in contact with the heat which has been transferred from the electronic components to the cooling plate 111, through the studs 111F. Subsequently, the flow of air heated in this way escapes from the duct system through the outlet holes 111E and enters into the fan 14. In particular, the flow of heated air, following the delivery flow, enters the fan 14 through the inlet 142A, and follows the return flow coming out of the fan through the outlet 142B. Lastly, the flow of air escapes from the fan 14 through the outlet opening 121 towards the outside environment.

## Claims

1. An audio amplifier (1) for automotive applications, comprising:
- a bottom wall (12);
- a shell (11), connected to the bottom wall (12) to form a housing space therebetween, the housing space being a closed space, wherein the shell (11) includes a cooling plate (111) parallel to the bottom wall (12) and having an inside face (111A), facing towards the housing space, and an outside face (111B) opposite the inside face (111A), the cooling plate (111) being provided with a finned portion (111C), projecting from the outside face (111B), and a plurality of studs (111F) jutting from the inside face (111A) into the housing space towards the bottom wall (12);
- an electronic card (15), positioned in the housing space and including a plurality of electronic components, positioned on the card (15) so that the studs (111F) of the plurality of studs of the cooling plate (111) are abutted thereagainst, the electronic card (15) being configured to amplify an audio signal;
- a lid (13), fixed to the shell (11) and positioned parallel to the bottom wall (12) so that the finned portion (111C) is interposed between the lid (13) and the outside face (111B) of the cooling plate (111) to define a duct system;
- a fan (14), mounted between the lid (13) and the outside face (111B) of the cooling plate (111), to generate an air flow through the duct system.

2. The audio amplifier (1) according to claim 1, wherein the studs (111F) of the plurality of studs are located at the finned portion (111C) of the cooling plate (111).

3. The audio amplifier (1) according to claim 1 or 2, wherein the shell (11) includes a lateral wall (112) having a front face (112A) and the amplifier (1) comprises one or more electrical connectors (16), mounted on the front face (112A) of the lateral wall (112) and connected to the electronic card (15).

4. The audio amplifier (1) according to claim 3, wherein the front face (112A) of the lateral wall (112) defines an outlet opening (121) which is in fluid communication with the duct system, the fan (14) being mounted between the finned portion (111C) and the outlet opening (121).

5. The audio amplifier (1) according to claim 4, wherein the lid (13) comprises a grid (131), located at the outlet opening (121) and made in one piece with the lid (13).

6. The audio amplifier (1) according to any one of claims 3 to 5, wherein the lateral wall (112) of the shell (11) has a first side face (112C) and a second side face (112D) and a rear face (112B), opposite the front face (112A), and the duct system has a plurality of inlet holes (111D), located on the first side face (112C), on the second side face (112D) and on the rear face (112B).

7. The audio amplifier (1) according to claim 5, wherein the outlet opening (121) is located at a central position of the front face (112A) and the duct system includes a plurality of outwardly radiating ducts to put the outlet opening (121) and the inlet holes (111D) of the duct system in fluid communication with each other.

8. The audio amplifier (1) according to any one of the preceding claims, wherein the shell (11) is made from a heat conductive metallic material and is a monolithic structure.

9. The audio amplifier (1) according to any one of the preceding claims, wherein the electronic components abutted against the studs (111F) of the plurality of studs include power switches and/or integrated electronic power components.

10. The audio amplifier (1) according to any one of the preceding claims, wherein the shell (11) comprises a group of fastening studs (111G) projecting from the inside face (111A) into the housing space, towards the bottom wall (12), and configured to fasten the electronic card (15) to the shell (15) by means of fastening screws.

11. A method for cooling an audio amplifier (1), comprising the following steps:
- providing a bottom wall (12) and a shell (11), connected to the bottom wall (12) to form a housing space therebetween, the housing space being a closed space, wherein the shell (11) includes a cooling plate (111) parallel to the bottom wall (12) and having an inside face (111A), facing towards the housing space, and an outside face (111B) opposite the inside face (111A), the cooling plate (111) being provided with a finned portion (111C) projecting from the outside face (111B) and a plurality of studs (111F) jutting from the inside face (111A) into the housing space towards the bottom wall (12);
- providing an electronic card (15), positioned in the housing space and including a plurality of electronic components, positioned on the card (15) so that the studs (111F) of the plurality of studs of the cooling plate (111) are abutted thereagainst, the electronic card (15) being configured to process an audio signal;
- providing a lid (13), fixed to the shell (11) and positioned parallel to the bottom wall (12) so that the finned portion (111C) is interposed between the lid (13) and the outside face (111B) of the cooling plate (111) to define a duct system;
- via a fan (14) which is mounted between the lid (13) and the outside face (111B) of the cooling plate (111), generating an air flow through the duct system.

12. The method according to claim 11, wherein the studs (111F) of the plurality of studs are located at the finned portion (111C) of the cooling plate (111).

13. The method according to claim 11 or 12, wherein the shell (13) includes a lateral wall (112) having a front face (112A) which defines an outlet opening (121), the method comprising a step of causing air to flow between the finned portion (111C) and the outlet opening (121) through the fan (14), which is mounted between the finned portion (111C) and the outlet opening (121).

14. The method according to claim 13, wherein the lateral wall (112) of the shell (11) has a first side face (112C) and a second side face (112D) and a rear face (112B), opposite the front face (112A), and the duct system has a plurality of inlet holes (111D), located on the first side face (112C), on the second side face (112D) and on the rear face (112E), and wherein the outlet opening (121) is located at a central position of the front face (112A) and the duct system includes a plurality of outwardly radiating ducts to put the outlet opening (121) and the inlet holes (111D) of the duct system in fluid communication with each other.

15. The method according to any one of claims 11 to 14, wherein the electronic components abutted against the studs (111F) of the plurality of studs include power switches and/or integrated electronic power components.
